Europäisches Patentamt

European Patent Office

Office européen des brevets

(19)

(11) Veröffentlichungsnummer: **0 282 797**

A2

## (12) EUROPÄISCHE PATENTANMELDUNG

(21) Anmeldenummer: 88102970.6

(22) Anmeldetag: 28.02.88

(51) Int. Cl.⁴: **H05K 9/00** , H01R 13/719 , H01H 1/00

(30) Priorität: 04.03.87 DE 3706964

(43) Veröffentlichungstag der Anmeldung:
21.09.88 Patentblatt 88/38

(84) Benannte Vertragsstaaten:
CH DE FR GB LI SE

(71) Anmelder: **SCHAFFNER ELEKTRONIK AG**
**Nordstrasse 11**
**CH-4708 Luterbach(CH)**

(72) Erfinder: **Imholz, Peter E.**
**Rehhubel**
**CH-4532 Feldbrunnen(CH)**

(74) Vertreter: **Blum, Rudolf Emil Ernst et al**
**c/o E. Blum & Co Patentanwälte Vorderberg 11**
**CH-8044 Zürich(CH)**

(54) **Baugruppe für ein elektrisches Filter sowie Filter und Gerätestecker mit einer solchen Baugruppe.**

(57) Die Baugruppe enthält eine eine Induktivität (6) und weitere passive elektrische Elemente (1-5) umfassende Mehrzahl von Bauelementen und eine Anschlussabschnitte (15,15',16,16',17,17',18,18') und Leiterabschnitte (11,11',12,12',13) aufweisende Leiteranordnung. Die Leiteranordnung ist als Stanzteil mit Trägerabschnitten (24,24',25) zum Halten der Leiterabschnitte ausgebildet. Die Bauelemente sind mit den Leiterabschnitten verbunden und bilden nach dem Entfernen der Trägerabschnitte eine Schaltungseinheit, bei der die Leiterabschnitte durch das Spulengehäuse (32) lagestabil gehalten werden.

Diese Baugruppe ist Teil eines Filters, das ferner eine Kappe (8) und eine mit dieser verschweisste Grundplatte (7) aufweist, auf der die Baugruppe mit dem Spulengehäuse befestigt ist. Die Baugruppe eignet sich besonders zur Bildung von Filterreihen im Baukastensystem.

Fig. 2

EP 0 282 797 A2

## Baugruppe für ein elektrisches Filter sowie Filter und Gerätestecker mit einer solchen Baugruppe

Die Erfindung betrifft eine Baugruppe für ein elektrisches Filter mit einer Anschlussabschnitte und Leiterabschnitte aufweisenden Leiteranordnung, die als Stanzteil mit mindestens einem Trägerabschnitt zum Halten der Leiterabschnitte ausgebildet ist, und mit einer mindestens eine Induktivität und weitere passive elektrische Elemente umfassende Mehrzahl von Bauelementen, die mit den Leiterabschnitten verbunden sind und nach dem Entfernen des Trägerabschnittes eine Schaltungseinheit bilden sowie ein Filter und einen Gerätestecker mit einer solchen Baugruppe.

In der US-PS 3 216 089 sind elektrische Baugruppen beschrieben, deren Bauelemente durch mindestens zwei Leiteranordnungen verbunden sind. Die Leiteranordnungen bestehen aus einer Anzahl von Leiterabschnitten, die in einer Ebene liegen und innerhalb eines Rahmenteiles durch Stege lagestabil gehalten werden. Die Anschlussdichte der Bauelemente werden mit den Leiterabschnitten verlötet und anschliessend werden der Rahmen und die Stege entfernt, so dass die Leiterabschnitte durch die Anschlussdrähte für die weitere Herstellung der Baugruppe lagestabil gehalten werden.

In der DE-AS 19 11 779 ist eine Verdrahtungsanordnung zur elektrischen Verbindung voneinander verschie dener Anschlussebenen beschrieben, bei der gestanzte, mittels durch trennbarer Querstege verbundene Leiterbahnen zur Verbindung der Bauelemente oder Baugruppen verwendet werden und die Leiterbahnen in einem Isolationskörper gehalten werden.

Aus dem DE-GM 18 77 052 ist eine ähnliche Anordnung bekannt, bei der ebenfalls eine Trägerplatte für die Leiterabschnitte vorhanden ist.

In der EP-PS 173 991 ist ein Gerätestecker mit integriertem elektrischen Entstörfilter beschrieben, bei dem auf einerSeite eines Isolierstoffplättchens die elektrischen Filterbauelemente und auf der anderen Seite ein Leiterabschnitt und Anschlussabschnitte liegen. Dieser Gerätestecker hat keine gestanzte Leiteranordnung.

Die Nachteile des Standes der Technik sind im wesentlichen darin zu sehen, dass einerseits die Leiterabschnitte durch die Anschlussdrähte lagestabil gehalten werden, so dass besondere Anforderungen an die Festigkeit der Anschlussdrähte zu stellen sind und dass andererseits ein Substrat verwendet wird, das die Haltefunktion übernimmt.

Während im ersten Fall für die weitere Verarbeitung der Baugruppe besondere Massnahmen zu treffen sind, weil die Baugruppe zuwenig stabil ist, sind im andern Fall die Anpassung bzw. Fertigstellung der Leiteranordnung auf bzw. mit dem Substrat ein zusätzlicher Vorgang, bei dem eine hohe Genauigkeit und eine komplizierte Handhabung erforderlich ist.

Die Aufgabe der Erfindung ist, eine elektrische Baugruppe der eingangs genannten Art zu schaffen, die in rationeller Massenfertigung hergestellt werden kann, eine sichere und unkomplizierte Behandlung als Baugruppe bei der Anwendung ermöglicht und zur Bildung ganzer Filterreihen im Baukastensystem geeignet ist.

Diese Aufgabe wird erfindungsgemäss mit den Merkmalen des Anspruches 1 gelöst.

Bei einem bevorzugten Ausführungsbeispiel der Erfindung ragen die Anschlussabschnitte für die Bauelemente aus der durch die Leiterabschnitte bestimmten Ebene heraus, so dass der Anschlussbereich bezüglich der Leiterabschnitte beabstandet ist.

Dies hat den Vorteil, dass zwischen den Leiterabschnitten und den Bauelementen eine Isolierschicht entfallen kann.

Insbesondere vorteilhaft ist, wenn im Anschlussbereich ein Schlitz vorgesehen ist, der mit der offenen Seite von den Leiterabschnitten wegzeigt, um die Anschlussdrähte der Bauelemente einzuführen, und wenn der Schlitz von Abschnitten unterschiedlicher Breite begrenzt ist, um den Anschlussdraht eines Bauelementes durch Verformen des schmalen Abschnittes festzuklemmen. Durch diese Ausgestaltung des Anschlussabschnittes kann die Leiteranordnung automatisch und maschinell mit den Bauelementen bestückt werden.

Ein Filter mit einer Baugruppe ist erfindungsgemäss durch die Merkmale des Patentanspruches 6 gekennzeichnet.

Die Vorteile dieses Filters sind darin zu sehen, dass es auf einer automatischen Fertigungsanlage vollständig und ohne Handarbeit hergestellt werden kann und dass die Zahl der Montageschritte minimal ist.

Ein Gerätestecker mit Baugruppe ist erfindungsgemäss durch die Merkmale des Patentanspruches 10 gekannzeichnet.

Im folgenden wird die Erfindung anhand der beiliegenden Zeichnungen näher erläutert.

Es zeigen:

Figur 1 ein Schaltschema eines Ausführungsbeispiels eines erfindungsgemässen Filters,

Figur 2 eine auseinandergezogen dargestellte, perspektivische Ansicht eines Filters gemäss dem Schaltschema nach Figur 1,

Figur 3 eine perspektivische Ansicht des in Figur 2 dargestellten Stanzteiles,

Figur 4 eine Ansicht auf eine Anschlussfahne der Leiteranordnung,

Figur 5 ein Ablaufplan der Montage des in Figur 2 gezeigten Filters,

Figur 6 eine auseinandergezogen dargestellte perspektivische Ansicht eines Ausführungsbeispiels eines Gerätesteckers mit integrierter Filterbaugruppe,

Figur 7 eine perspektivische Ansicht des in Figur 6 dargestellten Stanzteiles, und

Figur 8 eine Ansicht auf die Unterseite eines anderen Ausführungsbeispiels eines Gerätesteckers in den die in Figur 6 gezeigte Filterbaugruppe integriert ist.

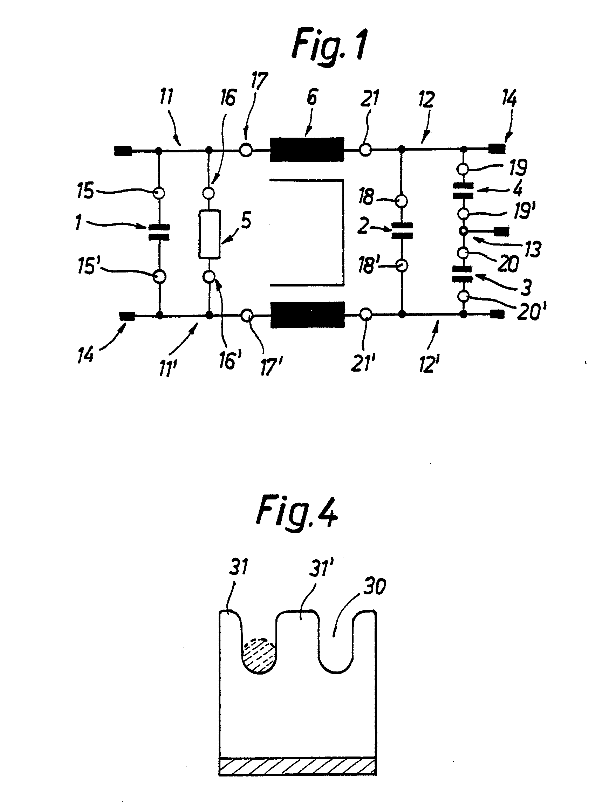

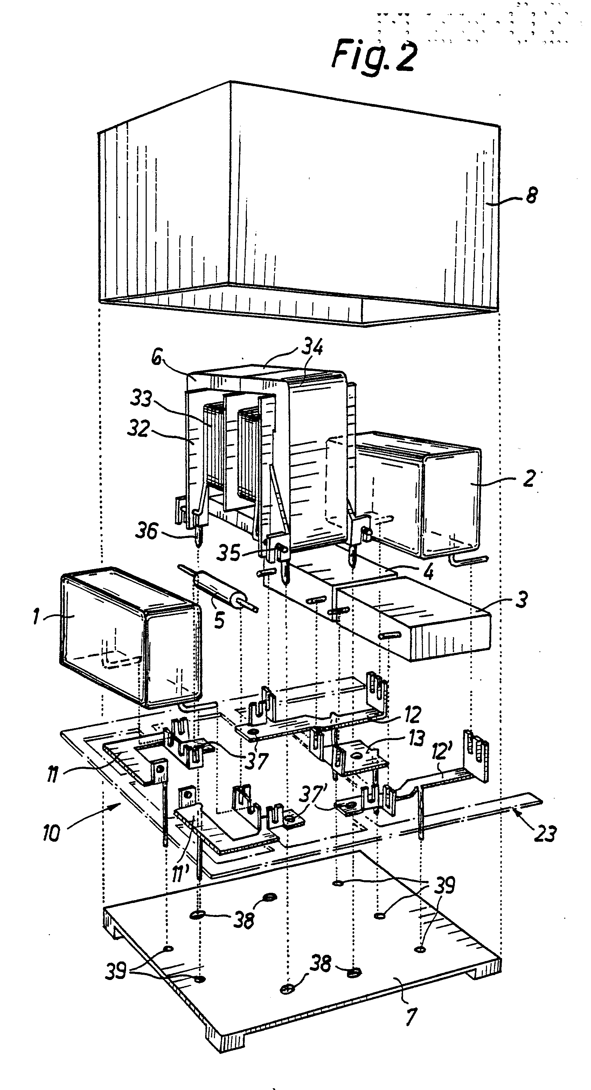

Bei dem Ausführungsbeispiel handelt es sich um ein Filter, dessen elektrischer Aufbau in Figur 1 und dessen mechanischer Aufbau in Figur 2 dargestellt ist. Wie aus den Figuren ersichtlich, ist das Filter aus Kondensatoren 1, 2, 3, 4, einem Widerstand 5 und einer Spule 6 aufgebaut. Da derartige Filter bekannt sind, wird die elektrische Funktion desselben nicht ausführlich beschrieben.

Das Filter ist in einem aus Grundplatte 7 und Kappe 8 bestehenden Gehäuse montiert. Die Grundplatte 7 und die Kappe 8 bestehen aus demselben Material, vorzugsweise aus Kunststoff und sind miteinander verschweisst.

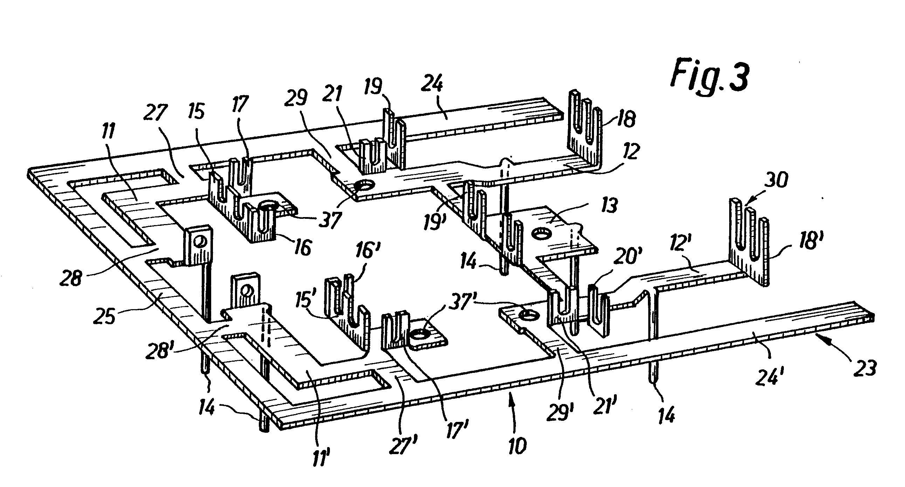

Die Grundlage für den mechanischen Filteraufbau bildet eine Leiteranordnung mit der die elektrischen Bauelemente 1 bis 6 verbunden sind. Diese Leiteranordnung ist Teil eines Stanzteiles 10, das aus bandförmigem elektrisch leitendem Material ausgestanzt ist. Die Leiteranordnung enthält fünf Leiterabschnitte 11,11'; 12,12' und 13. Wie Figur 3 zeigt, sind vier Leiterabschnitte 11,11' und 12,12' als paarweise zugeordnete spiegelsymmetrische Abschnitte im Abstand zueinander im Stanzteil 10 ausgebildet und der fünfte Leiterabschnitt 13 ist zwischen den Leiterabschnitten 12,12' im Stanzteil 10 ausgebildet. Je der Leiterabschnitt hat einen Anschlussstift 13. Ferner sind die Leiterabschnitte 11,11' mit einer Anschlussfahne 15,15' für den Kondensator 1, mit einer Anschlussfahne 16, 16' für das Widerstandselement 5 und mit einer Anschlussfahne 17,17' für die Spule 6 versehen. Die Leiterabschnitte 12,12' haben jeweils eine Anschlussfahne 18,18' für den Kondensator 2, eine Anschlussfahne 19,20' für die Kondensatoren 3 und 4 und eine Anschlussfahne 21,21' für die Spule 6 während der Leiterabschnitt 13 jeweils eine Anschlussfahne 19', 20 für die Kondensatoren 3 und 4 hat. Bei diesem Stanzteil 10 liegen die Leiterabschnitte in einer Ebene während die Anschlussstifte bezüglich der durch die Leiterabschnitte bestimmten Ebene nach unten ragend und die Anschlussfahnen bezüglich der durch die Leiterabschnitte bestimmten Ebene nach oben ragend am Stanzteil 10 ausgebildet sind. Die Leiteranordnung ist symmetrisch und dreidimensional.

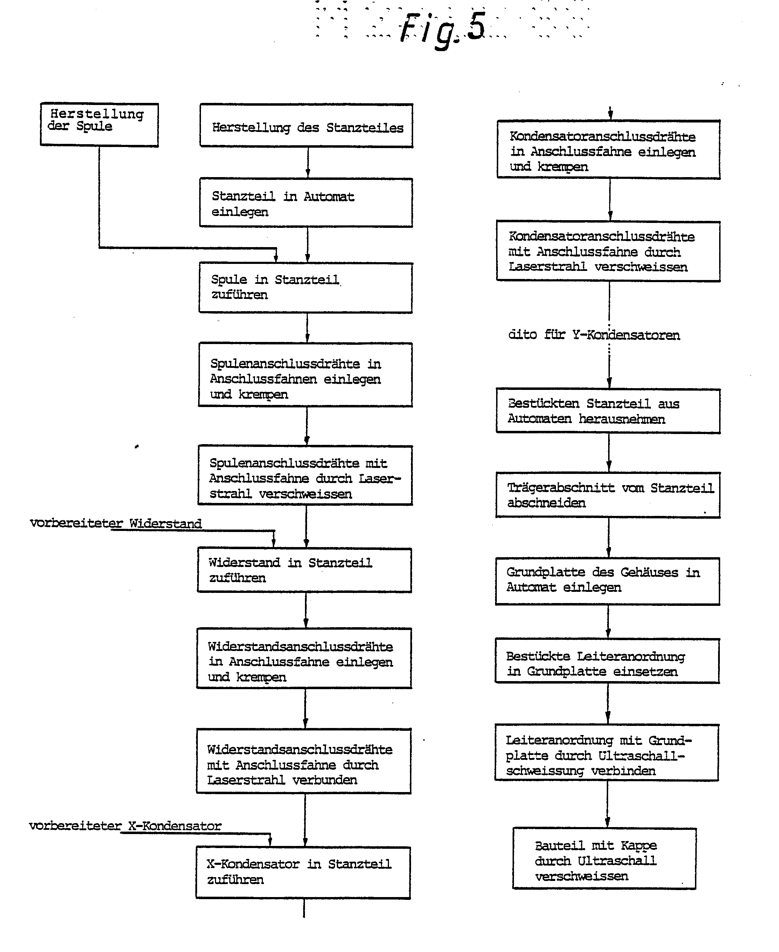

Der Stanzteil 10 hat ferner einen U-förmigen Abschnitt 23 mit parallel verlaufenden Schenkelabschnitten 24,24' und einem Basisabschnitt 25, die die Leiteranordnung an drei Seiten umgeben. Die Leiteranordnungen 11,11' sind jeweils über Stege 27,27' und 28,28' mit den Schenkelabschnitten 24,24' bzw. dem Basisabschnitt 25 verbunden, während die Leiterabschnitte 12,12' über Stege 29,29' jeweils mit einem Schenkelabschnitt 24 bzw. 24' verbunden sind. Die Ausbildung der Anschlussfahnen wird unter anderem durch die Bedingung bestimmt, dass die Bauelemente 1 bis 6 von oben eingesetzt werden. Aus diesem Grund sind die freien Endabschnitte der Anschlussfahnen mit einem oder mehreren Schlitzen 30 versehen, in die die Anschlussdrähte der elektrischen Bauelemente eingesetzt sind (Fig.4). Von den beiden Abschnitten 31,31', die jeweils einen Schlitz begrenzen, ist einer schmaler als der andere ausgebildet. Dadurch kann in vorteilhafter Weise der schmale Abschnitt in Richtung zum anderen Abschnitt gebogen werden. Dadurch wird der Anschlussdraht festgeklemmt und das elek trische Bauelement mechanisch gehalten. Der Anschlussdraht und die Anschlussfahne sind zudem jeweils miteinander verschweisst, um eine einwandfreie elektrische Verbindung herzustellen.

Beim vorliegenden Ausführungsbeispiel spielt erfindungsgemäss die Spule 6 eine zentrale Rolle bei der Ausbildung der Leiterabschnitte 11,11' und 12,12'. Wie Figur 2 zeigt enthält die Spule 6 einen durch eine Wandung in zwei Wicklungsabteile unterteilten Spulenkörper 32, zwei Wicklungen 33 und zwei E-Kerne 34. Die Anschlussdrähte 35 der Wicklungen sind an beiden Seiten des Spulengehäuses so herausgeführt, dass sie in die Anschlussfahnen 17,17'; 21, 21' einsetzbar sind. Das Spulengehäuse 32 ist mit vier Ansätzen 36 versehen, die einstückig mit dem Spulengehäuse 32 ausgebildet sind und von der Unterseite des Spulengehäuses 32 abstehen. Die Ansätze 36 sind konisch ausgebildet, um das Einsetzen in vorteilhafter Weise zu erleichtern.

Zur Lagestabilisierung der Leiteranordnung ist in den Leiterabschnitten 11,11' und 12,12' jeweils ein Durchgangsloch 37 vorgesehen, in die die Ansätze 36 des Spulengehäuses 32 einsteckbar sind. Die Ansätze 36 sind so bemessen, dass sie durch die Leiterabschnitte 11,11'; 12,12' hindurch in Löcher 38 eingreifen, die in der Grundplatte 7 ausgebildet sind. Das Spulengehäuse 32 besteht aus dem gleichen Kunststoff wie die Grundplatte 7. Die Ansätze 36 des Spulengehäuses 32 sind mit der Grundplatte 7 an der Unterseite derselben verschweisst, so dass die mit den elektrischen Bauelementen 1-6 bestückte Leiteranordnung auf der Grundplatte 7 befestigt ist, wobei zu beachten ist, dass die Trägerabschnitte vor dem Verschweissen bereits entfernt worden sind. Nachzutragen ist noch, dass die Anschlussstifte durch Löcher 39 in der Grundplatte 7 hindurchragen und nicht mit dieser verbunden sind.

Nachfolgend wird das Verfahren zur Herstellung des Filters beschrieben. Die Montage des Filters erfolgt auf einem Rundtisch mit einer Anzahl von Satellitenstationen. In Figur 5 ist der Ablauf bei der Herstellung des Filters dargestellt.

Die Spule 6 wird in einer Satellitenstation montiert, indem man auf den Spulenkörper die zwei gegeneinander isolierten Wicklungen wickelt, die Anschlussdrähte zum Anschliessen vorbereitet und die E-förmigen Kerne beidseitig an den Spulenkörper anbringt und miteinander verbindet, z.B. verleimt. In einer anderen Satellitenstation wird der Stanzteil so gestanzt, dass dieser als Rolle zugeführt wird. Anschliessend werden die Anschlussfahnen bzw. -stifte gebogen und der Stanzteil abgeschnitten.

Die Stanzteile werden im Rundtisch abgelegt. Danach wird eine Spule auf den Stanzteil aufgelegt, wobei die Anschlussdrähte in den Anschlussfahnen eingelegt werden. Anschliessend werden die Anschlussdrähte durch Laserimpulse an die Anschlussfahnen angeschweisst. Als nächster Schritt ist die Montage des Widerstandes vorgesehen. Hierbei werden bei dem ab Bund zugeführten Widerstand die Anschlussdrähte entsprechend zugeschnitten und in die entsprechenden Anschlussfahnen eingelegt. Nachdem der Widerstand durch Krempen eines Abschnittes beider Anschlussfahnen mechanisch befestigt ist, werden in der Folge die Anschlussdrähte und die entsprechenden Anschlussfahnen durch Laserimpulse miteinander verschweisst. Im Anschluss daran werden die Kondensatoren an dem Stanzteil befestigt und zwar in der gleichen Weise wie beim Widerstand. Der Stanzteil ist sodann fertig bestückt.

In dieser Form sind die elektrischen Bauelemente mit der im Stanzteil ausgebildeten Leiteranordnung fest verbunden, bilden aber noch keine elektrische Baugruppe, weil die Leiteranordnung durch den U-förmigen Trägerabschnitt elektrisch kurzgeschlossen ist.

In einem weiteren Schritt wird der U-förmige Trägerabschnitt abgeschnitten, so dass in vorteilhafter Weise eine elektrische Baugruppe mit fünf separaten Leiter abschnitten entsteht, die durch die elektrischen Bauelemente und insbesondere die Spule lagestabil gehalten werden. Anschliessend wird die Baugruppe in eine Grundplatte, die dem Rundtisch zuvor zugeführt worden ist, so eingelegt, dass die Ansätze des Spulengehäuses und die Anschlussstifte durch die Grundplatte erstrecken. In der nachfolgenden Ultraschallschweissung wird die Baugruppe mit der Grundplatte fest verbunden. In einer weiteren Satellitenstation wird die Grundplatte mit einer Kappe verschweisst.

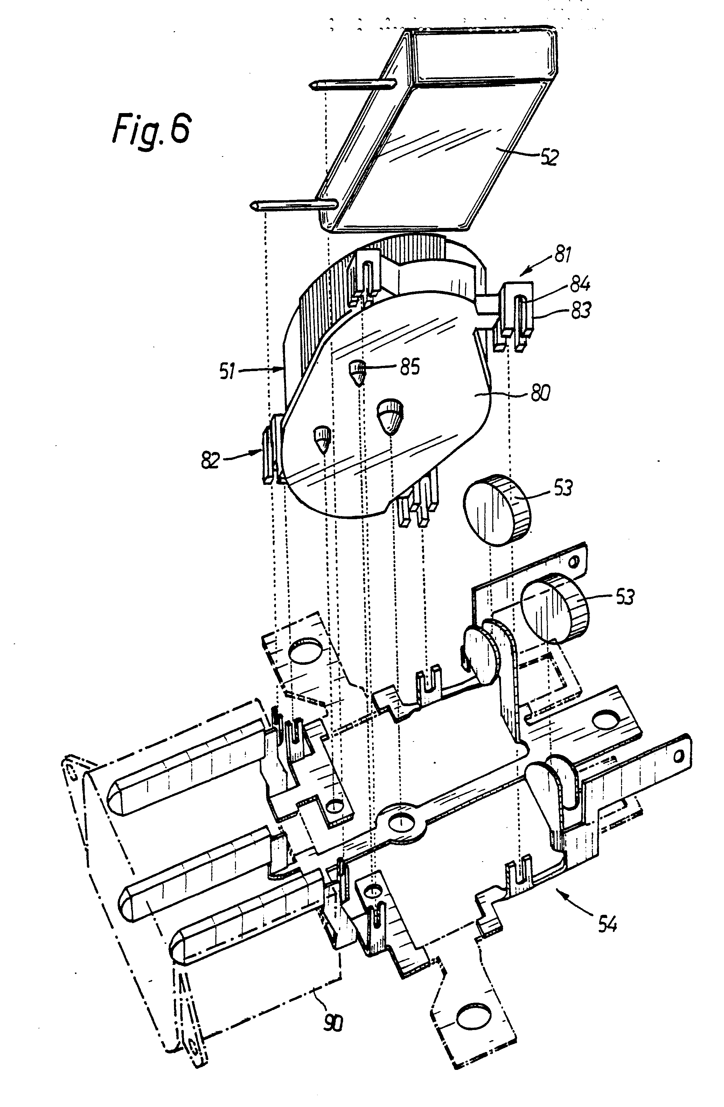

Der in Figur 6 dargestellte Gerätestecker hat eine Filterbaugruppe, die erfindungsgemäss zur Bildung ganzer Filterreihen im Baukastensystem geeignet ist.

Die Filterbaugruppe enthält eine Ringkernspule 51, einen X-kondensator 52, zwei Y-Kondensatoren 53 und eine Leiteranordnung, die diese elektrischen Bauteile zu einer Schaltungseinheit mit netzseitigen und geräteseitigen Anschlussorganen bildet.

Bei den Y-Kondensatoren handelt es sich um keramische Kondensatoren in Pillenform, die beidseitig eine elektrisch leitende Schicht zum Anschliessen aufweisen.

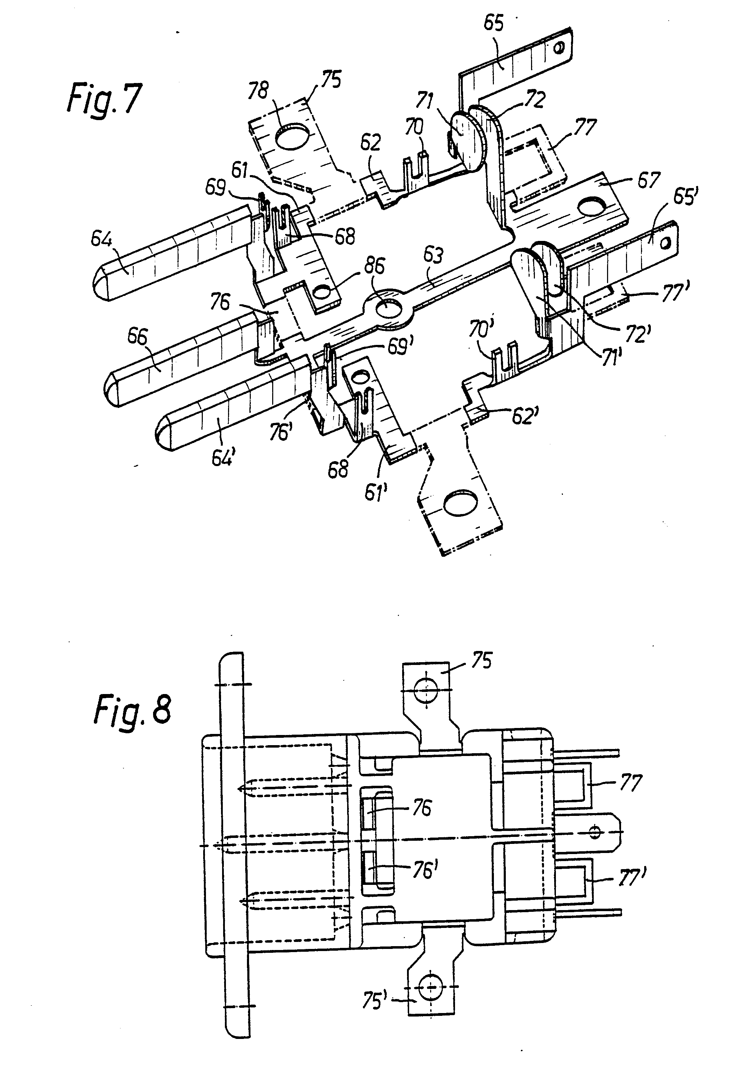

Die Leiteranordnung ist Teil eines Stanzteiles 54, das in Figur 7 dargestellt ist. Der Stanzteil 54 wird aus bandförmigen elektrisch leitendem Material ausgestanzt. Die Leiteranordnung enthält fünf Leiterabschnitte 61,61', 62,62' und 63, wobei vier Leiterabschnitte 61,61', 62, 62' als paarweise zugeordnete spiegelsymmetrische Abschnitte im Abstand zueinander und der fünfte Leiterabschnitt 63 zwischen diesen liegend im Stanzteil 54 ausgebildet sind. Die bezüglich der Symmetrieachse gegenüberliegend ausgebildeten Leiterabschnitte weisen jeweils ein Anschlussorgan 64,64', 65,65' auf, das einstückig mit dem Leiterab schnitt ausgebildet ist. Wie Figur 6 zeigt, bilden die Anschlussorgane 64,64' die netzseitigen Anschlussorgane und sind als Gerätesteckerstifte ausgebildet, und die Anschlussorgane 65,65' bilden die geräteseitigen Anschlussorgane und sind als Anschlussfahnen ausgebildet. Der fünfte Leiterabschnitt 63 bildet im vorliegenden Fall den Erdleiter dar und weist an einem Ende ein als Gerätestecker stift ausgebildetes Anschlussorgan 66 und am anderen Ende ein als Anschlussfahne ausgebildetes Anschlussorgan 67 auf. Wie Figur 7 zeigt, sind die Leiterabschnitte zur Hauptachse in einer Ebene liegend angeordnet und die Anschlussorgane im Abstand und im vorliegenden Fall, oberhalb dieser Ebene angeordnet. Dieser Abstand ist dabei so ausgelegt, dass erfindungsgemäss auf ein Isolierorgan zwischen dem den Erdleiter bildenden Leiterabschnitt 63 und den elektrischen Bauelementen 51-53 (Figur 6) verzichtet werden kann. Zu diesem Zweck weisen die Leiterabschnitte jeweils aus der durch die Leiterabschnitte gebildeten Ebene herausragende Teilabschnitte auf. Ferner weisen die Leiterabschnitte 61,61' jeweils eine Anschlussfahne 69,69' für den X-Kondensator 52 und eine Anschlussfahne 68,68' für die Ringkernspule 51 auf. Die Leiterabschnitte 62,62' haben jeweils eine Anschlussfahne 70,70' für die Ringkernspule 51. Die Anschlussfahnen 68,68'; 69,69' und 70,70' sind einstückig mit den Leiterabschnitten ausgebildet und ragen aus der durch die Leiterabschnitte gebildeten Ebene heraus. Im Anschlussbereich am freien Ende sind die Anschlussfahnen mit einem Schlitz 73 versehen, in die die Anschlussdrähte der Ringkernspule 51 und des X-Kondensators 52 eingelegt und eingelötet sind. Zum Anschliessen der zwei Y-Kondensatoren 53 sind erfindungsgemäss vier pat-ähnliche Anschlussbereiche versehen, von denen jeweils einer mit dem Leiterabschnitt 62,62′ und die anderen zwei mit dem Leiterabschnitt 63 einstückig ausgebildet sind. Diese Anschlussbereiche sind parallel und im Abstand zueinander so angeordnet, dass sie gegen die Y-Kondensatoren 53 vorgespannt sind, um diese gleichzeitig zu halten.

Die vorstehend beschriebenen Leiterabschnitte 61, 61′; 62,62′ und 63 sind innerhalb des Stanzteiles 54 über erste, zweite und dritte Trägerabschnitte 75,75′; 76,76′ und 77,77′ verbunden, die als Abschnitte des Stanzteiles ausgebildet sind. Diese Trägerabschnitte haben eine rein mechanische Funktion und werden ausschliesslich zur Herstellung des Gerätesteckers benötigt. Die ersten Trägerabschnitte 75,75′ weisen ein Loch 78,78′ auf, um den Stanzteil 54 in eine Fertigungsanlage einlegen und durch darin vorgesehene Fertigungsstationen verschieben zu können.

Wie beim eingangs beschriebenen Filter spielt beim Gerätestecker erfindungsgemäss die Ringkernspule 51 eine zentrale Rolle bei der Ausbildung der Leiterabschnitte. Die Ringkernspule 51 besteht aus einem nicht dargestellten Kern mit zwei Wicklungen und einem Spulengehäuse 80. An das Spulengehäuse 80 sind zwei Paar von Anschlussabschnitten 81,82 angeformt. Diese Anschlussabschnitte 81,82 sind in besonders vorteilhafter Weise U-förmig ausgebildet und zur Unterseite des Spulengehäuses 80 offen. In den Schenkeln 83 sind Schlitze 84 ausgebildet, die am freien Schenkelende offen sind und in die die Anschlussdrähte der Wicklungen so herausgeführt sind, dass die zwischen den Schenkeln 83 liegenden Drahtabschnitte beim Einsetzen der Ringkernspule 51 von oben in die Schlitze 73 einführbar sind, wobei die Schenkel 88 der Anschlussabschnitte 81,82 den Anschlussbereich der Anschlussfahnen 68,68′; 70,70′ teilweise übergreifen. Diese Ausführung ist insbesondere vorteilhaft für die automatische Bestückung der Leiteranordnung. Das Spulengehäuse 80 ist mit drei stiftähnlichen Ansätzen 85 versehen, die einstückig mit dem Spulengehäuse 80 ausgebildet sind und von der Bodenfläche des Spulengehäuses 80 abstehen.

Zur erfindungsgemässen Lagestabilisierung der Leiteranordnung 54 ist in den Leiterabschnitten 61,61′ und 63 jeweils ein Durchgangslöcher 86 vorgesehen, in die die stiftähnlichen Ansätze 85 des Spulengehäuses 80 hineinragen. Zur besseren Halterung der Leiterabschnitte können die Ansätze 85 so bemessen werden, dass diese durch die Durchgangslöcher 86 hindurchragen und nach dem Einführen durch Wärme verformt werden.

In der Figur 6 ist die Filterbaugruppe als integrierter Teil eines Gerätesteckers dargestellt, wobei wie mit strichpunktierten Linien dargestellt, die Gerätesteckerstifte 64,64′; 66 in Form eines IEC-Steckers 90 mit Kunststoff, z.B. thermoplastischem oder duroplastischem Kunststoff, umhüllt sind.

Das in Figur 8 dargestellte Ausführungsbeispiel eines Gerätesteckers enthält die in Figur 6 gezeigte Filterbaugruppe. Bei diesem Gerätestecker sind die Filterbauelemente 51-53 vollständig sowie die netzseitigen Gerätesteckerstifte 64,64′; 66 ähnlich wie in Figur 6 gezeigt und die geräteseitigen Anschlussorgane 65,65′; 67 teilweise mit Kunststoff umhüllt. Wie Figur 8 zeigt, werden die Trägerabschnitte 75,75′; 76,76′; 77,77′ an dem Stanzteil belassen, um den Spritzvorgang durchzuführen. Es wird darauf hingewiesen, dass die Trägerabschnitte aber bereits vor dem Spritzvorgang abgetrennt werden können.

Die beschriebenen Ausführungsbeispiele der Gerätestecker können zusätzlich mit einem Metallgehäuse (nicht dargestellt) versehen sein, das mit dem Anschlussorgan 67 elektrisch verbunden ist.

**Ansprüche**

1. Baugruppe für ein elektrisches Filter mit einer Anschlussabschnitte und Leiterabschnitte aufweisenden Leiteranordnung, die als Stanzteil mit mindestens einem Trägerabschnitt zum Halten der Leiterabschnitte ausgebildet ist, und mit einer mindestens eine Induktivität und weitere passive elektrische Elemente umfassende Mehrzahl von Bauelementen, die mit den Leiterabschnitten verbunden sind und nach dem Entfernen des Trägerabschnittes eine Schaltungseinheit bilden, dadurch gekennzeichnet, dass mindestens ein Bauelement (6; 51) ein Tragteil (32) mit Ansätzen (36) aufweist, durch die die Lage der Leiterabschnitte (11,11′,12,12′,13; 61,61′,62,62′,63) in der Leiteranordnung bestimmt ist und die die Leiterabschnitte (11,11′, 12,12′,13; 61,61′,62,62′,63) nach dem Entfernen des Trägerabschnittes lagestabil halten.

2. Baugruppe nach Anspruch 1, dadurch gekennzeichnet, dass die Induktivität (6; 51) mit dem Tragteil (32;80) versehen ist.

3. Baugruppe nach Anspruch 1, dadurch gekennzeichnet, dass die Induktivität (6) und ein weiteres Bauelement (1-5; 52,53) einzeln oder gemeinsam mit einem Tragteil (32;80) versehen sind.

4. Baugruppe nach Anspruch 1, dadurch gekennzeichnet, dass die Anschlussabschnitte (68,68′,69,69′,70, 70′) für die Bauelemente (1-6; 51-53) aus der durch die Leiterabschnitte bestimmten Ebene herausragen, so dass die Anschlussbereiche bezüglich der Leiterabschnitte (11,11′, 12,12′,13; 61,61′,62,62′,63) beabstandet sind.

5. Baugruppe nach Anspruch 4, dadurch gekennzeichnet, dass im Anschlussbereich mindestens ein Schlitz (30;73) vorgesehen ist, der mit der offenen Seite von den Leiterabschnitten (11,11′,12,12′,13,13′; 61,61′,62,62′,63) wegzeigt, um die Anschlussdrähte der Bauelemente einzuführen, und dass der Schlitz (30;73) von Abschnitten unterschiedlicher Breite begrenzt ist, um den Anschlussdraht eines Bauelementes (1-6; 51-53) durch Verformen des schmaleren Abschnittes festzuklemmen.

6. Filter mit Baugruppe nach Anspruch 1, gekennzeichnet durch eine Grundplatte (7), die durch die Leiterabschnitte durchgreifende Ansätze (36) des Gehäuses (32) mit der Schaltungseinheit nach dem Entfernen des Trägerabschnittes verbunden ist, so dass die Leiterabschnitte auf der einen Oberfläche angeordnet sind, und durch eine Kappe (8), die mit der Grundplatte (7) zu einem Gehäuse für die Schaltungseinheit verbunden ist.

7. Filter nach Anspruch 6, dadurch gekennzeichnet, dass die geräteseitigen Anschlussorgane als Anschlussstifte (14) ausgebildet sind.

8. Filter nach einem der Ansprüche 7 oder 8, dadurch gekennzeichnet, dass die Kappe (8) mit nach innen abstehenden Abschnitten versehen ist, um die Induktivität (6) und/oder weitere elektrische Bauelemente (1-5) der Baugruppe zu fixieren.

9. Filter nach einem der Ansprüche 7 oder 8, dadurch gekennzeichnet, dass Löcher (39) mit einem Dichtungsabschnitt für die Anschlussstifte (14) in der Grundplatte (7) vorgesehen sind.

10. Gerätestecker mit Baugruppe nach Anspruch 1, dadurch gekennzeichnet, dass die netzseitigen Gerätestekkerstifte (64,66) und die geräteseitigen Anschlussorgane (65,67) einstückig mit der Leiteranordnung ausgebildet sind und dass die Baugruppe mit oder ohne Trägerabschnitte mindestens teilweise mit Kunststoff umhüllt sind.

11. Gerätestecker nach Anspruch 10, dadurch gekennzeichnet, dass mindestens die netzseitigen Gerätesteckerstifte (90) in Form eines Gerätesteckers mit Kunststoff umhüllt sind. (Fig. 6)

12. Gerätestecker nach Anspruch 10, dadurch gekennzeichnet, dass die Filterbauelemente vollständig sowie die netzseitigen Gerätesteckerstifte und die geräteseitigen Anschlussorgane teilweise in Form eines Gerätesteckers mit Kunststoff umhüllt sind. (Fig. 8)

# Fig.1

# Fig.4

# Fig.2

*Fig.3*

0 282 797

0 282 797

# Fig. 5

Herstellung der Spule

Herstellung des Stanzteiles

Stanzteil in Automat einlegen

Spule in Stanzteil zuführen

Spulenanschlussdrähte in Anschlussfahnen einlegen und krempen

Spulenanschlussdrähte mit Anschlussfahne durch Laserstrahl verschweissen

vorbereiteter Widerstand

Widerstand in Stanzteil zuführen

Widerstandsanschlussdrähte in Anschlussfahne einlegen und krempen

Widerstandsanschlussdrähte mit Anschlussfahne durch Laserstrahl verbunden

vorbereiteter X-Kondensator

X-Kondensator in Stanzteil zuführen

Kondensatoranschlussdrähte in Anschlussfahne einlegen und krempen

Kondensatoranschlussdrähte mit Anschlussfahne durch Laserstrahl verschweissen

dito für Y-Kondensatoren

Bestückten Stanzteil aus Automaten herausnehmen

Trägerabschnitt vom Stanzteil abschneiden

Grundplatte des Gehäuses in Automat einlegen

Bestückte Leiteranordnung in Grundplatte einsetzen

Leiteranordnung mit Grundplatte durch Ultraschallschweissung verbinden

Bauteil mit Kappe durch Ultraschall verschweissen

*Fig.6*

Fig.7

Fig.8